# EUROPEAN PATENT SPECIFICATION

(11) **EP 4 207 262 B1**
(45) Date of publication and mention of the grant of the patent: **23.04.2025**
(21) Application number: 22836480.8
(22) Date of filing: 16.02.2022
(51) Int. Cl.: H01L 21/768, H01L 21/60, H01L 23/48, H01L 25/065

(54) **SEMICONDUCTOR STRUCTURE AND PREPARATION METHOD THEREFOR**
HALBLEITERSTRUKTUR UND HERSTELLUNGSVERFAHREN DAFÜR
STRUCTURE SEMI-CONDUCTRICE ET SON PROCÉDÉ DE PRÉPARATION

(30) Priority: 09.07.2021 CN 202110779490
(43) Date of publication of application: 05.07.2023
(73) Proprietor: Changxin Memory Technologies, Inc., Hefei City, Anhui 230000 (CN)
(72) Inventor: LIU, Chih-cheng, Hefei, Anhui 230000 (CN)
(74) Representative: Lavoix
(86) International application number: PCT/CN2022/076466
(87) International publication number: WO 2023/279720

(56) References cited:
- CN-A- 105 321 903
- CN-A- 107 316 855
- US-A1- 2011 171 582
- US-A1- 2015 179 546
- US-A1- 2017 186 799
- US-A1- 2018 068 984
- US-A1- 2018 240 859
- US-B1- 10 607 924

## Description

### Technical Field

The present application relates to the technical field of integrated circuits (ICs), and in particular to a semiconductor structure and a manufacturing method thereof.

### Background

The through silicon via (TSV) technology is a high-density packaging technology, and a fourth packaging technology as a promising replacement for mature wire bonding. The TSV technology implements the vertical electrical interconnection by filling conductive materials such as copper, tungsten and polycrystalline silicon. It can transmit a signal from one side of the chip to the other side of the chip and implement three-dimensional (3D) integration for multiple layers of chips in combination with chip stacking. The TSV technology is an important development trend of the semiconductors in the future. Through the vertical interconnection, it can effectively shorten the interconnecting line between chips and reduce the signal delay to achieve the better signal transmission performance, higher working frequency, wider broadband and higher device integration of the electronic system.

A TSV process mainly includes deep silicon etching for forming micro holes, deposition of an insulating layer/a barrier layer/a seed layer, deep hole filling, chemical-mechanical polishing (CMP), thinning, pad manufacturing, re-distribution line manufacturing, etc. The conventional TSV process is implemented by forming a TSV in a front side of the chip, establishing metal interconnection at the front side of the chip to form electrical connection, thinning the semiconductor chip, and leading out an electrode from a back side of the chip.

However, for the conventional TSV process in which the TSV is only formed in one chip, when two or more chips are bonded together, adjacent chips are connected electrically by an additional conductive structure (such as a solder ball or a conductive bump) to make the structure and manufacturing process more complicated. Background may be found in US2015/179546A1 and US10607924B1.

### Summary

In view of the problems in the background art, there is a need to provide a semiconductor structure and a manufacturing method thereof to implement metal interconnection without an additional solder ball.

The invention is set out in the appended set of claims.

By forming the TSV penetrating through the second chip and a part of the first chip, and forming the conductive layer in the TSV, the manufacturing method of a semiconductor structure in the present application can implement electrical connection between the metal layers in the first chip and the second chip without an additional conductive structure, and thus can simplify the semiconductor structure and the process steps. With the inclined sidewall of the second part, the manufacturing method only forms the insulating layer on the sidewall of the first part to simplify the process steps and reduce the cost.

With the TSV penetrating through the second chip and a part of the first chip, and the conductive layer in the TSV, the semiconductor structure in the present application can implement electrical connection between the metal layers in the first chip and the second chip without an additional conductive structure, and thus the semiconductor structure and the process steps are simplified. With the inclined sidewall of the second part, the semiconductor structure only forms the insulating layer on the sidewall of the first part to simplify the process steps and reduce the cost.

### Brief Description of the Drawings

To describe the technical solutions in the embodiments of the present application or in the conventional art more clearly, the following briefly describes the accompanying drawings required for describing the embodiments or the conventional art.
FIG. 1 is a schematic sectional view of a semiconductor structure;
FIG. 2 is a flowchart of a manufacturing method of a semiconductor structure;
FIG. 3 is a schematic sectional view of a structure obtained in Step S1 in a manufacturing method of a semiconductor structure;
FIG. 4 is a schematic sectional view of a structure obtained in Step S2 in a manufacturing method of a semiconductor structure;
FIG. 5 is a flowchart of Step S3 in a manufacturing method of a semiconductor structure;
FIG. 6 is a schematic sectional view of a structure obtained in Step S301 in a manufacturing method of a semiconductor structure;
FIG. 7 is a schematic sectional view of a structure obtained in Step S302 and also a schematic sectional view of a structure obtained in Step S3 in a manufacturing method of a semiconductor structure;
FIG. 8 is a schematic sectional view of a structure obtained in Step S4 in a manufacturing method of a semiconductor structure, and also a schematic structural view of a semiconductor structure; and
FIG. 9 is a flowchart of Step S4 in a manufacturing method of a semiconductor structure.

Reference numerals:
11. first chip, 111. substrate, 112. dielectric layer, 113. metal layer, 114. pad, 12. second chip, 13. TSV. 131. first part, 132. second part, 14. insulating layer, 15. conductive layer, 16. bonding layer, 17. solder ball, and 401. insulating material layer.

### Detailed Description

To facilitate the understanding of the present application, the present application will be described more completely below with reference to the accompanying drawings. Preferred embodiments of the present application are shown in the accompanying drawings.

The embodiments are provided to make the present application more thorough and comprehensive.

Unless otherwise defined, all technical and scientific terms used herein have the same meaning as commonly understood by those skilled in the technical field of the present application.

It should be understood that when an element or a layer is described as "being on", "being adjacent to", "being connected to" or "being coupled to" another element or layer, it can be on, adjacent to, connected to, or coupled to the another element or layer directly, or intervening elements or layers may be present. On the contrary, when an element is described as "being directly on", "being directly adjacent to", "being directly connected to" or "being directly coupled to" another element or layer, there are no intervening elements or layers. It should be understood that although terms such as first and second may be used to describe various elements, components, regions, layers, doped types and/or sections, these elements, components, regions, layers, doped types and/or sections should not be limited by these terms. These terms are only used to distinguish one element, component, region, layer, doped type or section from another element, component, region, layer, doped type or section. Thus, a first element, component, region, layer, doped type or section discussed below may be termed a second element, component, region, layer or section without departing from the teachings of the present application. For example, the first chip may become the second chip; and similarly, the second chip may become the first chip. The first chip and the second chip are different chips.

Spatial relationship terms such as "under", "beneath", "lower", "below", "above", and "upper" can be used herein to describe the relationship shown in the figure between one element or feature and another element or feature. It should be understood that in addition to the orientations shown in the figure, the spatial relationship terms further include different orientations of used and operated devices. For example, if a device in the accompanying drawings is turned over and described as being "beneath another element", "below it", or "under it", the device or feature is oriented "on" the another element or feature. Therefore, the exemplary terms "beneath" and "under" may include two orientations of above and below. In addition, the device may further include other orientations (for example, a rotation by 90 degrees or other orientations), and the spatial description used herein is interpreted accordingly.

In this specification, the singular forms of "a", "an" and "the" may also include plural forms, unless clearly indicated otherwise. It should also be understood that terms "include" and/or "comprise", when used in this specification, may determine the presence of features, integers, steps, operations, elements and/or components, but do not exclude the presence or addition of one or more other features, integers, steps, operations, elements, components and/or groups. In this case, in this specification, the term "and/or" includes any and all combinations of related listed items.

Embodiments of the present application are described herein with reference to cross-sectional illustrations that are schematic diagrams of idealized embodiments (and intermediate structures) of the present application, such that variations shown in the shapes can be contemplated due to, for example, manufacturing techniques and/or tolerances. Therefore, the embodiments of the present application should not be limited to the specific shapes of the regions shown herein, but include shape deviations due to, for example, manufacturing technologies. Therefore, the regions shown in the figure are schematic in nature, and their shapes are not intended to show the actual shapes of the regions of the device and limit the scope of the present application.

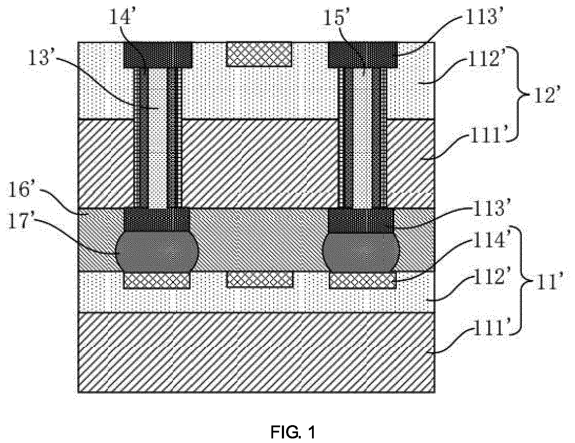

FIG. 1 shows a conventional semiconductor structure. The conventional semiconductor structure includes a stacked structure, a TSV 13', an insulating layer 14' and a conductive layer 15'. The stacked structure includes a first chip 11' and a second chip 12'. The second chip 12' is bonded onto the first chip 11' in an F2F manner through a bonding layer 16'. The first chip 11' and the second chip 12' each include a substrate 111', a dielectric layer 112' on the substrate 111' and a metal layer 113' in the dielectric layer 112'. The TSV 13' penetrates through the substrate 111' of the second chip 12' and the dielectric layer 112' of the second chip 12'. The insulating layer 14' is located on a sidewall of a first part 131'. The conductive layer 15' is located in the TSV 13' and fills up the TSV 13'. The conductive layer 15' is electrically connected to the penetrated metal layer 113' in each of the first chip 11' and the second chip 12'. However, as the TSV 13' is only located in the second chip 12' in the conventional semiconductor structure shown in FIG. 1, there is a need for an additional solder ball 17' to establish the metal interconnection, and thus the manufacturing process is complicated.

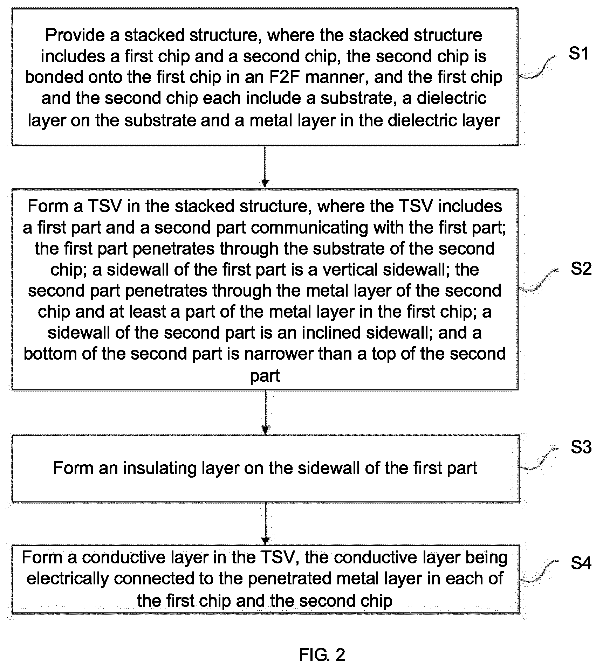

Referring to FIG. 2, the present application provides a manufacturing method of a semiconductor structure, including the following steps:
S1: Provide a stacked structure, where the stacked structure includes a first chip and a second chip, the second chip is bonded onto the first chip in an F2F manner, and the first chip and the second chip each include a substrate, a dielectric layer on the substrate and a metal layer in the dielectric layer.
S2: Form a TSV in the stacked structure, where the TSV includes a first part and a second part communicating with the first part; the first part penetrates through the substrate of the second chip; a sidewall of the first part is a vertical sidewall; the second part penetrates through the metal layer of the second chip and at least a part of the metal layer in the first chip; a sidewall of the second part is an inclined sidewall; and a bottom of the second part is narrower than a top of the second part.
S3: Form an insulating layer on the sidewall of the first part.
S4: Form a conductive layer in the TSV, the conductive layer being electrically connected to the penetrated metal layer in each of the first chip and the second chip.

By forming the TSV penetrating through the second chip and a part of the first chip, and forming the conductive layer in the TSV, the manufacturing method of a semiconductor structure in the present application can implement electrical connection between the metal layers in the first chip and the second chip without an additional conductive structure, and thus can simplify the semiconductor structure and the process steps. With the inclined sidewall of the second part, the manufacturing method only forms the insulating layer on the sidewall of the first part to simplify the process steps and reduce the cost. In addition, by bonding the second chip onto the first chip in the F2F manner, the structure obtained further has the advantages of the high precision, small size of the stacked structure, high input/output (I/O) density, short interconnecting line, small parasitic parameter of the lead, etc.

Preferably, the bonding between the first chip and the second chip may be implemented with wafer level packaging (WLP) such as wafer on wafer (WOW) or chip on wafer (COW), and may also be implemented with chip scale package (CSP).

Preferably, in a manufacturing method provided by some embodiments, the sidewall of the second part may have an inclination angle of 60-80° with respect to a surface of the substrate, such as 60°, 65°, 70°, 75° or 80°. In a manufacturing method provided by some embodiments, the TSV may have a depth of 50-100 µm, such as 50 µm, 65 µm, 80 µm or 100 µm. In a manufacturing method provided by some embodiments, the TSV may have a width of 2-10 µm, such as 2 µm, 4 µm, 6 µm, 8 µm or 10 µm. In the manufacturing method of a semiconductor structure provided by the present application, there are no limits made on the specific inclination angle of the sidewall of the second part with respect to the surface of the substrate, the specific depth of the TSV and the specific width of the TSV.

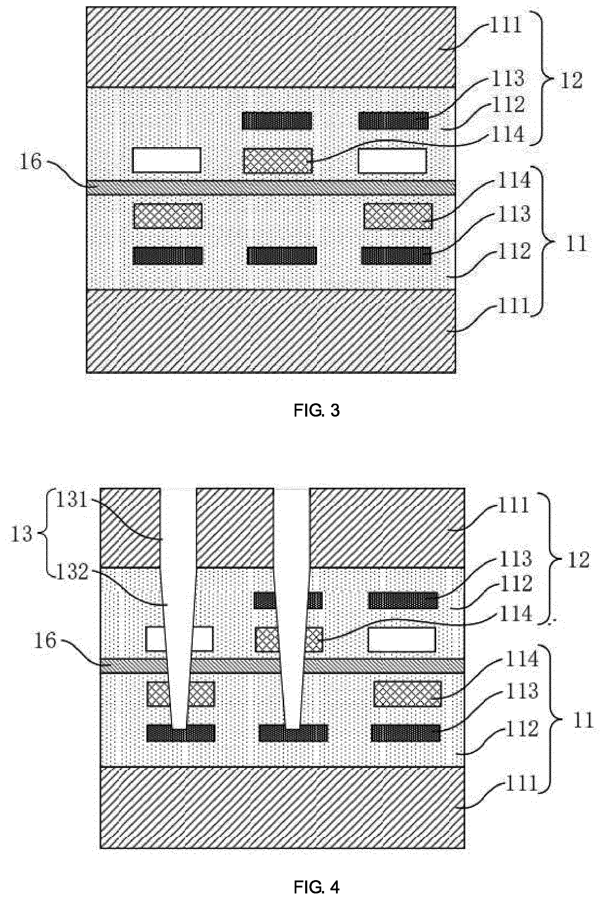

In Step S1, referring to S1 in FIG. 2 and FIG. 3, a stacked structure is provided. The stacked structure includes a first chip 11 and a second chip 12. The second chip 12 is bonded onto the first chip 11 in an F2F manner. The first chip 11 and the second chip 12 each include a substrate 111, a dielectric layer 112 on the substrate 111 and a metal layer 113 in the dielectric layer 112.

Referring also to FIG. 3, in an embodiment, Step S1 may include the following steps:
Provide the first chip 11.
Provide the second chip 12, and bond the second chip 12 onto the first chip 11 in the F2F manner.

In an embodiment, the substrate 111 may include, but is not limited to, a silicon substrate, a silicon nitride substrate or a silicon oxynitride substrate. The dielectric layer 112 may include, but is not limited to, a silicon dioxide layer or a silicon nitride layer. There are no limits made on the material of the substrate 111 and the dielectric layer 112 in the present application.

Specifically, the dielectric layer 112 may be located at a front side of the substrate 111. The so-called term "F2F" means that after the second chip 12 is bonded onto the first chip 11, the dielectric layer 112 of the second chip 12 and the dielectric layer 112 of the first chip 11 are bonded together, as shown in FIG. 3. It can be considered that the front side of the first chip 11 is upward, and the second chip 12 with the downward front side is bonded onto the first chip 11.

Referring also to FIG. 3, in an embodiment, the first chip 11 and the second chip 12 each may further include a pad 114. The pad 114 is located at a side of the metal layer 113 away from the substrate 111. In the above embodiment, the TSV 13 further penetrates through the pad 114 in the first chip 11 and the pad 114 in the second chip 12.

In an embodiment, a through via (not shown) may be reserved in the metal layer 113 and the pad 114 separately. The through via corresponds to the subsequent TSV 13 and becomes a part of the TSV 13 upon formation of the TSV 13.

According to the manufacturing method of a semiconductor structure provided by the above embodiment, the through via is reserved in the metal layer 113 and the pad 114 separately. The reserved through via is filled with the dielectric layer 112 when the dielectric layer 112 covering the metal layer 113 and the pad 114 is formed. Consequently, during the subsequent formation of the TSV 13, the etching step upon the etching of the substrate 111 is to etch the dielectric layer 112, rather than to alternately etch the dielectric layer 112 and the metal layer 113 or the pad 114, thus simplifying the process steps and improving the production efficiency.

Preferably, the pad 114 may include, but is not limited to, a copper pad. There are no limits made on the material of the pad 114 in the present application.

In Step S2, referring to S2 in FIG. 2 and FIG. 4, a TSV 13 is formed in the stacked structure. The TSV 13 includes a first part 131 and a second part 132 communicating with the first part 131. The first part 131 penetrates through the substrate 111 of the second chip 12. A sidewall of the first part 131 is a vertical sidewall. The second part 132 penetrates through the metal layer 113 of the second chip 12 and at least a part of the metal layer 113 in the first chip 11. A sidewall of the second part 132 is an inclined sidewall. A bottom of the second part 132 is narrower than a top of the second part 132.

Referring also to FIG. 4, in an embodiment, Step S2 may include the following step:
Etch the first chip 11 and the second chip 12 to form the TSV 13.

Referring to FIG. 4, in an embodiment, the second chip 12 may be bonded onto the first chip 11 through a bonding layer 16. In the above embodiment, the TSV 13 may further penetrate through the bonding layer 16.

In an embodiment, the bonding layer 16 may include, but is not limited to, an aluminum/copper composite layer. There are no limits made on the material and structure of the bonding layer 16 in the present application.

Due to a high-temperature working environment, the stable performance of the system is restricted by the conventional aluminum wire. The copper metal has the advantages of better thermal conductivity, better electrical conductivity and lower thermal expansion coefficient than the aluminum metal, but copper wire bonding is hardly applied to the semiconductors. The manufacturing method of a semiconductor structure provided by the above embodiment takes the aluminum/copper composite layer as the bonding layer 16, in which the aluminum metal can provide the desirable bonding, while the copper metal can provide the desirable electrical, mechanical and thermal properties.

In an embodiment, in the step of etching the first chip 11 and the second chip 12 to form the TSV 13, dry etching may be used to etch the first chip 11 and the second chip 12 to form the TSV 13.

In an embodiment, after the dry etching is used to etch the first chip 11 and the second chip 12 to form the TSV 13, the stacked structure may further be etched with wet etching to widen the TSV 13, thus fully exposing the pad 114 in each of the first chip 11 and the second chip 12.

In Step S3, referring to S3 in FIG. 2 and FIGS. 5-7, an insulating layer 14 is formed on the sidewall of the first part 131.

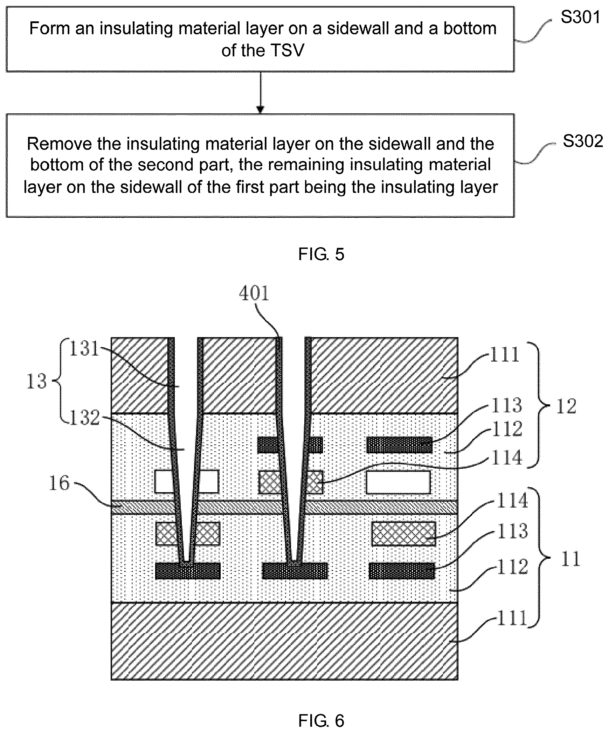

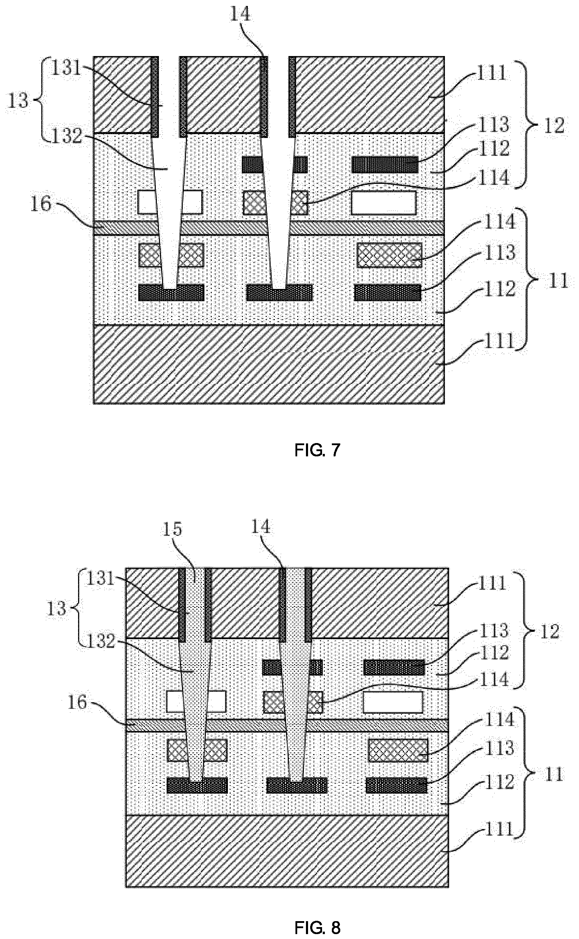

As shown in FIG. 5, in an embodiment, Step S3 may include the following steps:
S301: Form an insulating material layer 401 on a sidewall and a bottom of the TSV 13, as shown in FIG. 6.
S302: Remove the insulating material layer 401 on the sidewall and the bottom of the second part 132, the remaining insulating material layer 401 on the sidewall of the first part 131 being the insulating layer 14, as shown in FIG. 7.

According to the manufacturing method of a semiconductor structure provided by the above embodiment, with the inclined sidewall of the second part, the insulating material layer on the sidewall and the bottom of the second part can be removed directly, and the insulating layer is only formed on the sidewall of the first part. Therefore, the structure obtained can directly form electrical connection between the metal layers in the first chip and the second chip through the conductive layer in the TSV without an additional solder ball or distribution line, thus simplifying the process steps and reducing the cost.

In an embodiment, the insulating material layer 401 may include, but is not limited to, an oxide layer. There are no limits made on the material and structure of the insulating material layer 401 in the present application.

In Step S302, referring to S302 in FIG. 5 and FIG. 7, the insulating material layer 401 on the sidewall and the bottom of the second part 132 is removed, the remaining insulating material layer 401 on the sidewall of the first part 131 being the insulating layer 14.

In an embodiment, the insulating material layer 401 on the sidewall and the bottom of the second part 132 may be removed with, but not limited to, the dry etching.

In an embodiment, after Step S302, the stacked structure may further be etched with the wet etching to widen the TSV 13, thus fully exposing the pad 114 in each of the first chip 11 and the second chip 12.

In Step S4, referring to S4 in FIG. 2 and FIGS. 8-9, a conductive layer 15 is formed in the TSV 13. The conductive layer 15 is electrically connected to the penetrated metal layer 113 in each of the first chip 11 and the second chip 12.

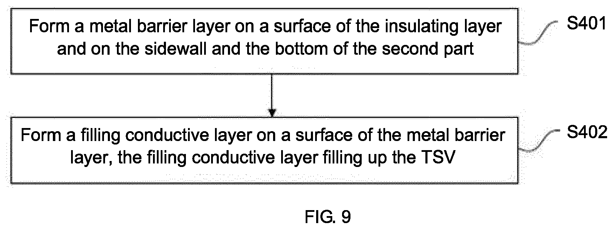

As shown in FIG. 9, in an embodiment, Step S4 may further include the following steps:
S401: Form a metal barrier layer on a surface of the insulating layer 14 and on the sidewall and the bottom of the second part 132.
S402: Form a filling conductive layer 15 on a surface of the metal barrier layer, the filling conductive layer 15 filling up the TSV 13.

It should be understood that although the steps in the flowcharts of FIG. 2, FIG. 5 and FIG. 9 are shown in sequence according to the arrows, these steps are unnecessarily executed in the sequence indicated by the arrows. The execution order of these steps is not strictly limited, and these steps may be executed in other orders, unless clearly described otherwise. Moreover, at least one of the steps in FIG. 2, FIG. 5 and FIG. 9 may include a plurality of steps or stages. The steps or stages are unnecessarily executed at the same time, but may be executed at different times. The execution order of the steps or stages is unnecessarily carried out sequentially, but may be executed alternately with other steps or at least one of the steps or stages of other steps.

Referring also to FIG. 8, the present application further provides a semiconductor structure, including a stacked structure, a TSV 13, an insulating layer 14 and a conductive layer 15. The stacked structure includes a first chip 11 and a second chip 12. The second chip 12 is bonded onto the first chip 11 in an F2F manner. The first chip 11 and the second chip 12 each include a substrate 111, a dielectric layer 112 on the substrate 111 and a metal layer 113 in the dielectric layer 112. The TSV 13 includes a first part 131 and a second part 132 communicating with the first part 131. The first part 131 penetrates through the substrate 111 of the second chip 12. A sidewall of the first part 131 is a vertical sidewall. The second part 132 penetrates through the metal layer 113 of the second chip 12 and at least a part of the metal layer 113 in the first chip 11. A sidewall of the second part 132 is an inclined sidewall. A bottom of the second part 132 is narrower than a top of the second part 132. The insulating layer 14 is located on the sidewall of the first part 131. The conductive layer 15 is located in the TSV 13 and fills up the TSV 13. The conductive layer 15 is electrically connected to the penetrated metal layer 113 in each of the first chip 11 and the second chip 12.

With the TSV penetrating through the second chip and a part of the first chip, and the conductive layer in the TSV, the semiconductor structure in the present application can implement electrical connection between the metal layers in the first chip and the second chip without an additional conductive structure, and thus the semiconductor structure and the process steps can be simplified. With the inclined sidewall of the second part, the semiconductor only forms the insulating layer on the sidewall of the first part to simplify the process steps and reduce the cost.

In an embodiment, the substrate 111 may include, but is not limited to, a silicon substrate, a sapphire substrate, a silicon nitride substrate or a silicon oxynitride substrate. The dielectric layer 112 may include, but is not limited to, a silicon dioxide layer or a silicon nitride layer. There are no limits made on the material of the substrate 111 and the dielectric layer 112 in the present application.

Referring also to FIG. 8, in an embodiment, the first chip 11 and the second chip 12 each may further include a pad 114. Specifically, the pad 114 may be located at a side of the metal layer 113 away from the substrate 111. The pad 114 may include, but is not limited to, a copper pad. There are no limits made on the material of the pad 114 in the present application.

On the basis of the above embodiment, the TSV 13 further penetrates through the pad 114 in the first chip 11 and the pad 114 in the second chip 12.

Preferably, in a semiconductor structure provided by some embodiments, the sidewall of the second part may have an inclination angle of 60-80° with respect to a surface of the substrate, such as 60°, 65, 70°, 75° or 80°. In a semiconductor structure provided by some embodiments, the TSV may have a depth of 50-100 µm, such as 50 µm, 65 µm, 80 µm or 100 µm. In a semiconductor structure provided by some embodiments, the TSV may have a width of 2-10 µm, such as 2 µm, 4 µm, 6 µm, 8 µm or 10 µm. In the semiconductor structure provided by the present application, there are no limits made on the specific inclination angle of the sidewall of the second part with respect to the surface of the substrate, the specific depth of the TSV and the specific width of the TSV.

Referring also to FIG. 8, in an embodiment, the semiconductor structure may further include a bonding layer 16. Specifically, the bonding layer 16 is located between the first chip 11 and the second chip 12, and contacts the dielectric layer 112 of the first chip 11 and the dielectric layer 112 of the second chip 12. The bonding layer 16 may include, but is not limited to, an aluminum/copper composite layer. There are no limits made on the material and structure of the bonding layer 16 in the present application.

Due to a high-temperature working environment, the stable performance of the system is restricted by the conventional aluminum wire. The copper metal has the advantages of better thermal conductivity, better electrical conductivity and lower thermal expansion coefficient than the aluminum metal, but copper wire bonding is hardly applied to the semiconductors. The manufacturing method of a semiconductor structure provided by the above embodiment takes the aluminum/copper composite layer as the bonding layer 16, in which the aluminum metal can provide the desirable bonding, while the copper metal can provide the desirable electrical, mechanical and thermal properties.

In an embodiment, the conductive layer 15 may include a metal barrier layer and a filling conductive layer. The metal barrier layer is located on a surface of the insulating layer and on the sidewall and the bottom of the second part. The filling conductive layer is located on a surface of the metal barrier layer and fills up the TSV 13.

In an embodiment, the metal barrier layer may include, but is not limited to, a tantalum layer, and a metal barrier layer made of other materials or a stacked structure thereof. There are no limits made on the material and form of the metal barrier layer.

In an embodiment, the insulating layer 14 may include, but is not limited to, a pad oxide layer.

Specifically, in some embodiments, the pad oxide layer may include, but is not limited to, a silicon dioxide layer or other oxide layers. There are no limits made on the structure and material of the pad oxide layer.

## Claims

1. A manufacturing method of a semiconductor structure, comprising:
providing a stacked structure, wherein the stacked structure comprises a first chip (11) and a second chip (12), the second chip (12) is bonded onto the first chip (11)in a face-to-face (F2F) manner, and the first chip (11) and the second chip (12)each comprise a substrate (111), a dielectric layer (112)on the substrate (111) and a metal layer (113) in the dielectric layer (112) (S1);
forming a through silicon via (TSV) (13) in the stacked structure, wherein the TSV (13) comprises a first part (131) and a second part (132) communicating with the first part (131); the first part (131) penetrates through the substrate (111) of the second chip (12); a sidewall of the first part (131) is a vertical sidewall; the second part (132) penetrates through the metal layer (113) of the second chip (12) and at least a part of the metal layer (113) in the first chip (11); a sidewall of the second part (132) is an inclined sidewall; and a bottom of the second part (132) is narrower than a top of the second part (132) (S2);
forming an insulating layer (14) on the sidewall of the first part (131) (S3); and
forming a conductive layer (15) in the TSV(13), the conductive layer (15) being electrically connected to the penetrated metal layer (113) in each of the first chip (11) and the second chip (12) (S4);
**characterized in that**,
forming an insulating layer (14) on the sidewall of the first part (131) (S3) comprises:
forming an insulating material layer (401) on a sidewall and a bottom of the TSV (13); and
removing the insulating material layer (401) on the sidewall and the bottom of the second part (132) with dry etching, the remaining insulating material layer (401) on the sidewall of the first part (131) being the insulating layer (14).

2. The manufacturing method according to claim 1, wherein the first chip (11) and the second chip (12) each further comprise a pad (114), the pad (114) is located at a side of the metal layer (113) away from the substrate (111), and the TSV (13) further penetrates through the pad (114) in the first chip (11) and the pad (114) in the second chip (12).

3. The manufacturing method according to claim 1, wherein the sidewall of the second part (132) has an inclination angle of 60-80° with respect to a surface of the substrate (111).

4. The manufacturing method according to claim 1, wherein the TSV (13) has a depth of 50-100 µm and a width of 2-10 µm.

5. The manufacturing method according to claim 1, wherein the providing a stacked structure (S1) comprises:
providing the first chip (11); and
providing the second chip (12), and bonding the second chip (12) onto the first chip (11) in the F2F manner; and
the forming a TSV (13) in the stacked structure (S2) comprises:
etching the first chip (11) and the second chip (12) by an etching process to form the TSV (13).

6. The manufacturing method according to claim 5, wherein the second chip (12) is bonded onto the first chip (11) through a bonding layer (16); and the TSV (13) further penetrates through the bonding layer (16).

7. The manufacturing method according to any one of claims 1 to 6, wherein the forming a conductive layer (15) in the TSV (13) (S4) comprises:
forming a metal barrier layer on a surface of the insulating layer (14) and on the sidewall and the bottom of the second part (132); and
forming a filling conductive layer on a surface of the metal barrier layer, the filling conductive layer filling up the TSV (13).

8. A semiconductor structure, comprising:
a stacked structure, wherein the stacked structure comprises a first chip (11) and a second chip (12), the second chip (12) is bonded onto the first chip (11) in a face-to-face (F2F) manner, and the first chip (11) and the second chip (12) each comprise a substrate (111), a dielectric layer (112) on the substrate (111) and a metal layer (113) in the dielectric layer (112);
a through silicon via (TSV) (13), wherein the TSV (13) comprises a first part (131) and a second part (132) communicating with the first part (131); the first part (131) penetrates through the substrate (111) of the second chip (12); a sidewall of the first part (131) is a vertical sidewall; the second part (132) penetrates through the metal layer (113) of the second chip (12) and at least a part of the metal layer (113) in the first chip (11); a sidewall of the second part (132) is an inclined sidewall; and a bottom of the second part (132) is narrower than a top of the second part (132);
an insulating layer (14), located on the sidewall of the first part (131); and
a conductive layer (15), located in the TSV (13) and filling up the TSV (13), the conductive layer (15) being electrically connected to the penetrated metal layer (113) in each of the first chip (11) and the second chip (12);
**characterized in that**
the conductive layer (15) filling up the TSV has a diameter at a bottom of the first part (131) which is smaller than a diameter of said conductive layer at a top of the second part (132).

9. The semiconductor structure according to claim 8, wherein the first chip (11) and the second chip (12) each further comprise a pad (114), the pad (114) is located at a side of the metal layer (113) away from the substrate (111), and the TSV (13) further penetrates through the pad (114) in the first chip (11) and the pad (114) in the second chip (12).

10. The semiconductor structure according to claim 8, wherein the sidewall of the second part (132) has an inclination angle of 60-80° with respect to a surface of the substrate (111).

11. The semiconductor structure according to claim 9, wherein the TSV (13) has a depth of 50-100 µm and a width of 2-10 µm.

12. The semiconductor structure according to claim 8, wherein, the semiconductor structure further comprises: a bonding layer (16), located between the first chip (11) and the second chip (12), and contacting the dielectric layer (112) of the first chip (11) and the dielectric layer (112) of the second chip (12).

13. The semiconductor structure according to any one of claims 8 to 12, wherein the conductive layer (15) comprises:
a metal barrier layer, located on a surface of the insulating layer (14) and on the sidewall and the bottom of the second part (132); and
a filling conductive layer, located on a surface of the metal barrier layer and filling up the TSV (13).

14. The semiconductor structure according to claim 13, wherein the metal barrier layer comprises a tantalum layer, and the insulating layer (14) comprises a pad oxide layer.

## Patentansprüche

1. Verfahren zum Herstellen einer Halbleiterstruktur, umfassend:
Bereitstellen einer gestapelten Struktur, wobei die gestapelte Struktur einen ersten Chip (11) und einen zweiten Chip (12) umfasst, der zweite Chip (12) Face to Face (F2F) auf den ersten Chip (11) gebondet ist und der erste Chip (11) und der zweite Chip (12) jeweils ein Substrat (111), eine dielektrische Schicht (112) auf dem Substrat (111) und eine Metallschicht (113) in der dielektrischen Schicht (112) (S1) umfassen;
Bilden einer Silizium-Durchkontaktierung (TSV) (13) in der gestapelten Struktur, wobei die TSV (13) einen ersten Teil (131) und einen zweiten Teil (132) umfasst, der mit dem ersten Teil (131) in Verbindung steht; der erste Teil (131) das Substrat (111) des zweiten Chips (12) durchdringt; eine Seitenwand des ersten Teils (131) eine vertikale Seitenwand ist; der zweite Teil (132) die Metallschicht (113) des zweiten Chips (12) und mindestens einen Teil der Metallschicht (113) in dem ersten Chip (11) durchdringt; eine Seitenwand des zweiten Teils (132) eine schräge Seitenwand ist und eine Unterseite des zweiten Teils (132) schmaler ist als eine Oberseite des zweiten Teils (132) (S2);
Bilden einer Isolierschicht (14) auf der Seitenwand des ersten Teils (131) (S3); und
Bilden einer leitenden Schicht (15) in der TSV (13), wobei die leitende Schicht (15) elektrisch mit der durchdrungenen Metallschicht (113) in jedem des ersten Chips (11) und des zweiten Chips (12) verbunden ist (S4);
**dadurch gekennzeichnet, dass**
das Bilden einer Isolierschicht (14) auf der Seitenwand des ersten Teils (131) (S3) Folgendes umfasst:
Bilden einer Isoliermaterialschicht (401) auf einer Seitenwand und einem Boden der TSV (13); und
Entfernen der Isoliermaterialschicht (401) an der Seitenwand und dem Boden des zweiten Teils (132) durch Trockenätzen, wobei die verbleibende Isoliermaterialschicht (401) an der Seitenwand des ersten Teils (131) die Isolierschicht (14) ist.

2. Herstellungsverfahren nach Anspruch 1, wobei der erste Chip (11) und der zweite Chip (12) ferner jeweils eine Kontaktfläche (114) aufweisen, die Kontaktfläche (114) an einer vom Substrat (111) entfernten Seite der Metallschicht (113) angeordnet ist und die TSV (13) ferner die Kontaktfläche (114) im ersten Chip (11) und die Kontaktfläche (114) im zweiten Chip (12) durchdringt.

3. Herstellungsverfahren nach Anspruch 1, wobei die Seitenwand des zweiten Teils (132) einen Neigungswinkel von 60-80° in Bezug auf eine Oberfläche des Substrats (111) aufweist.

4. Herstellungsverfahren nach Anspruch 1, wobei die TSV (13) eine Tiefe von 50-100 µm und eine Breite von 2-10 µm aufweist.

5. Herstellungsverfahren nach Anspruch 1, wobei das Bereitstellen einer gestapelten Struktur (S1) Folgendes umfasst:
Bereitstellen des ersten Chips (11); und
Bereitstellen des zweiten Chips (12) und Bonden des zweiten Chips (12) Face to Face (F2F) auf den ersten Chip (11); und
wobei das Bilden einer TSV (13) in der gestapelten Struktur (S2) Folgendes umfasst:
Ätzen des ersten Chips (11) und des zweiten Chips (12) durch einen Ätzprozess zum Bilden der TSV (13).

6. Herstellungsverfahren nach Anspruch 5, wobei der zweite Chip (12) durch eine Bonding-Schicht (16) auf den ersten Chip (11) gebondet ist und die TSV (13) ferner die Bonding-Schicht (16) durchdringt.

7. Herstellungsverfahren nach einem der Ansprüche 1 bis 6, wobei das Bilden einer leitenden Schicht (15) in der TSV (13) (S4) Folgendes umfasst:
Bilden einer Metallsperrschicht auf einer Oberfläche der Isolierschicht (14) und auf der Seitenwand und dem Boden des zweiten Teils (132); und
Bilden einer leitenden Füllschicht auf einer Oberfläche der Metallsperrschicht, wobei die leitende Füllschicht die TSV (13) auffüllt.

8. Halbleiterstruktur, umfassend:
eine gestapelte Struktur, wobei die gestapelte Struktur einen ersten Chip (11) und einen zweiten Chip (12) umfasst, der zweite Chip (12) Face to Face (F2F) auf den ersten Chip (11) gebondet ist und der erste Chip (11) und der zweite Chip (12) jeweils ein Substrat (111), eine dielektrische Schicht (112) auf dem Substrat (111) und eine Metallschicht (113) in der dielektrischen Schicht (112) umfassen;
eine Silizium-Durchkontaktierung (TSV) (13), wobei die TSV (13) einen ersten Teil (131) und einen zweiten Teil (132) umfasst, der mit dem ersten Teil (131) in Verbindung steht; der erste Teil (131) das Substrat (111) des zweiten Chips (12) durchdringt; eine Seitenwand des ersten Teils (131) eine vertikale Seitenwand ist; der zweite Teil (131) die Metallschicht (113) des zweiten Chips (12) und mindestens einen Teil der Metallschicht (113) in dem ersten Chip (11) durchdringt; eine Seitenwand des zweiten Teils (132) eine schräge Seitenwand ist und eine Unterseite des zweiten Teils (132) schmaler ist als eine Oberseite des zweiten Teils (132);
eine Isolierschicht (14), die sich an der Seitenwand des ersten Teils (131) befindet; und
eine leitende Schicht (15), die in der TSV (13) angeordnet ist und die TSV (13) auffüllt, wobei die leitende Schicht (15) elektrisch mit der durchdrungenen Metallschicht (113) in jedem des ersten Chips (11) und des zweiten Chips (12) verbunden ist;
**dadurch gekennzeichnet, dass**
die leitende Schicht (15), die die TSV ausfüllt, an der Unterseite des ersten Teils (131) einen Durchmesser hat, der kleiner ist als der Durchmesser der genannten leitenden Schicht an der Oberseite des zweiten Teils (132).

9. Halbleiterstruktur nach Anspruch 8, wobei der erste Chip (11) und der zweite Chip (12) ferner jeweils eine Kontaktfläche (114) aufweisen, die Kontaktfläche (114) an einer vom Substrat (111) entfernten Seite der Metallschicht (113) angeordnet ist und die TSV (13) ferner die Kontaktfläche (114) im ersten Chip (11) und die Kontaktfläche (114) im zweiten Chip (12) durchdringt.

10. Halbleiterstruktur nach Anspruch 8, wobei die Seitenwand des zweiten Teils (132) einen Neigungswinkel von 60-80° in Bezug auf eine Oberfläche des Substrats (111) aufweist.

11. Halbleiterstruktur nach Anspruch 9, wobei die TSV (13) eine Tiefe von 50-100 µm und eine Breite von 2-10 µm aufweist.

12. Halbleiterstruktur nach Anspruch 8, wobei die Halbleiterstruktur ferner Folgendes umfasst: eine Bonding-Schicht (16), die sich zwischen dem ersten Chip (11) und dem zweiten Chip (12) befindet und die dielektrische Schicht (112) des ersten Chips (11) und die dielektrische Schicht (112) des zweiten Chips (12) verbindet.

13. Halbleiterstruktur nach einem der Ansprüche 8 bis 12, wobei die leitende Schicht (15) Folgendes umfasst:
eine Metallsperrschicht, die sich auf einer Oberfläche der Isolierschicht (14) und auf der Seitenwand und dem Boden des zweiten Teils (132) befindet; und
eine leitende Füllschicht, die sich auf einer Oberfläche der Metallsperrschicht befindet und die TSV (13) auffüllt.

14. Halbleiterstruktur nach Anspruch 13, wobei die Metallsperrschicht eine Tantalschicht umfasst und die Isolierschicht (14) eine Kontaktflächen-Oxidschicht umfasst.

## Revendications

1. Procédé de fabrication d'une structure à semi-conducteur, comprenant :
la fourniture d'une structure empilée, dans laquelle la structure empilée comprend une première puce (11) et une seconde puce (12), la seconde puce (12) est collée sur la première puce (11) en face à face (F2F), et la première puce (11) et la seconde puce (12) comprennent chacune un substrat (111), une couche diélectrique (112) sur le substrat (111) et une couche métallique (113) dans la couche diélectrique (112) (S1) ;
la formation d'un via de silicium traversant (TSV) (13), dans la structure empilée, dans lequel le TSV (13) comprend une première partie (131) et une seconde partie (132) communiquant avec la première partie (131) ; la première partie (131) pénètre à travers le substrat (111) de la seconde puce (12) ; une paroi latérale de la première partie (131) est une paroi latérale verticale ; la seconde partie (132) traverse la couche métallique (113) de la seconde puce (12) et au moins une partie de la couche métallique (113) de la première puce (11) ; une paroi latérale de la seconde partie (132) est une paroi latérale inclinée ; et un fond de la seconde partie (132) est plus étroit qu'un sommet de la seconde partie (132) (S2) ;
la formation d'une couche isolante (14) sur la paroi latérale de la première partie (131) (S3) ; et
la formation d'une couche conductrice (15) dans le TSV (13), la couche conductrice (15) étant électriquement connectée à la couche métallique pénétrée (113) dans la première puce (11) et la seconde puce (12) (S4) ;
**caractérisé en ce que**,
la formation d'une couche isolante (14) sur la paroi latérale de la première partie (131) (S3) comprend :
la formation d'une couche de matériau isolant (401) sur une paroi latérale et un fond du TSV (13) ; et
l'élimination de la couche de matériau isolant (401) sur la paroi latérale et le fond de la seconde partie (132) par une gravure à sec, la couche de matériau isolant restante (401) sur la paroi latérale de la première partie (131) étant la couche isolante (14).

2. Procédé de fabrication selon la revendication 1, dans lequel la première puce (11) et la seconde puce (12) comprennent chacune un tampon (114), le tampon (114) est situé sur un côté de la couche métallique (113) éloigné du substrat (111), et le TSV (13) pénètre ultérieurement à travers le tampon (114) dans la première puce (11) et le tampon (114) dans la seconde puce (12).

3. Procédé de fabrication selon la revendication 1, dans lequel la paroi latérale de la seconde partie (132) présente un angle d'inclinaison de 60 à 80° par rapport à la surface du substrat (111).

4. Procédé de fabrication selon la revendication 1, dans lequel le TSV (13) présente une profondeur de 50 à 100 µm et une largeur de 2 à 10 µm.

5. Procédé de fabrication selon la revendication 1, dans lequel la fourniture d'une structure empilée (S1) comprend :
la fourniture de la première puce (11) ; et
la fourniture de la seconde puce (12), et le collage de la seconde puce (12) sur la première puce (11) selon le procédé F2F ; et
la formation d'un TSV (13) dans la structure empilée (S2) comprend :
le gravage de la première puce (11) et de la seconde puce (12) par un processus de gravure pour former le TSV (13).

6. Procédé de fabrication selon la revendication 5, dans lequel la seconde puce (12) est collée sur la première puce (11) par une couche de liaison (16) ; et le TSV (13) pénètre en outre à travers la couche de liaison (16).

7. Procédé de fabrication selon l'une quelconque des revendications 1 à 6, dans lequel la formation d'une couche conductrice (15) dans le TSV (13) (S4) comprend :
la formation d'une couche barrière métallique sur une surface de la couche isolante (14) et sur la paroi latérale et le fond de la seconde partie (132) ; et
la formation d'une couche conductrice de remplissage sur une surface de la couche de barrière métallique, la couche conductrice de remplissage remplissant le TSV (13).

8. Structure semi-conductrice, comprenant :
une structure empilée, dans laquelle la structure empilée comprend une première puce (11) et une seconde puce (12), la seconde puce (12) est collée sur la première puce (11) en face à face (F2F), et la première puce (11) et la seconde puce (12) comprennent chacune un substrat (111), une couche diélectrique (112) sur le substrat (111) et une couche métallique (113) dans la couche diélectrique (112) ;
un via de silicium traversant (TSV) (13), dans lequel le TSV (13) comprend une première partie (131) et une seconde partie (132) communiquant avec la première partie (131) ; la première partie (131) pénètre à travers le substrat (111) de la seconde puce (12) ; une paroi latérale de la première partie (131) est une paroi verticale ; la seconde partie (131) traverse la couche métallique (113) de la seconde puce (12) et au moins une partie de la couche métallique (113) de la première puce (11) ; une paroi latérale de la seconde partie (132) est une paroi inclinée ; et un fond de la seconde partie (132) est plus étroite que la partie supérieure de la seconde partie (132) ;
une couche isolante (14), située sur la paroi latérale de la première partie (131) ; et
une couche conductrice (15), située dans le TSV (13) et remplissant le TSV (13), la couche conductrice (15) étant électriquement connectée à la couche métallique pénétrée (113) dans chacune de la première puce (11) et de la seconde puce (12) ;
**caractérisé en ce que**
la couche conductrice (15) remplissant le TSV présente un diamètre au bas de la première partie (131) qui est plus petit que le diamètre de ladite couche conductrice au sommet de la seconde partie (132).

9. Structure semi-conductrice selon la revendication 8, dans laquelle la première puce (11) et la seconde puce (12) comprennent chacune une pastille (114), la pastille (114) est située sur un côté de la couche métallique (113) éloigné du substrat (111), et le TSV (13) pénètre à travers la pastille (114) dans la première puce (11) et la pastille (114) dans la seconde puce (12).

10. Structure semi-conductrice selon la revendication 8, dans laquelle la paroi latérale de la seconde partie (132) présente un angle d'inclinaison de 60 à 80° par rapport à la surface du substrat (111).

11. Structure semi-conductrice selon la revendication 9, dans laquelle le TSV (13) présente une profondeur de 50-100 pm et une largeur de 2-10 µm.

12. Structure semi-conductrice selon la revendication 8, dans laquelle la structure semi-conductrice comprend en outre : une couche de liaison (16), située entre la première puce (11) et la seconde puce (12), et en contact avec la couche diélectrique (112) de la première puce (11) et la couche diélectrique (112) de la seconde puce (12).

13. Structure semi-conductrice selon l'une quelconque des revendications 8 à 12, dans laquelle la couche conductrice (15) comprend :
une couche barrière métallique, située sur une surface de la couche isolante (14) et sur la paroi latérale et le fond de la seconde partie (132) ; et
une couche conductrice de remplissage, située sur une surface de la couche de barrière métallique et le remplissage du TSV (13).

14. Structure semi-conductrice selon la revendication 13, dans laquelle la couche barrière métallique comprend une couche de tantale, et la couche isolante (14) comprend une couche d'oxyde tampon.
